# EUROPÄISCHE PATENTANMELDUNG

(11) **EP 0 693 788 A1**
(43) Veröffentlichungstag der Anmeldung: **24.01.1996**
(21) Anmeldenummer: 95108847.5
(22) Anmeldetag: 08.06.1995
(51) Int. Cl.: H01L 41/09

(54) **Biegeaktuator**

(30) Priorität: 15.07.1994 DE 4425078
(71) Anmelder: MARCO SYSTEMANALYSE UND ENTWICKLUNG GmbH, D-85221 Dachau (DE)
(72) Erfinder: Voigt, Konrad, D-07639 Bad Kloster Lausnitz (DE); Meikstat, Wolfgang, D-07629 Hermsdorf (DE)
(74) Vertreter: Schaumburg, Thoenes & Thurn

(57) **Zusammenfassung**

Ein Biegeaktuator (1) enthält ein piezoelektrisches Biegeglied (2), das durch Anlegen von Spannung zwischen wenigstens zwei Lagen schaltbar ist. Eine mit dem Biegeglied (2) zusammenwirkende Krafteinrichtung (3) unterstützt das Biegeglied (2) beim Übergang in wenigstens eine seiner Lagen.

## Beschreibung

Die Erfindung betrifft einen Biegeaktuator nach dem Oberbegriff des Anspruchs 1 sowie ein Betriebsverfahren für einen derartigen Biegeaktuator.

Der Fachwelt grundsätzlich bekannte Biegeaktuatoren enthalten ein piezoelektrisches Biegeglied, das durch Anlegen von Spannung zwischen wenigstens zwei Lagen schaltbar ist.

Eingesetzt werden derartige Piezo-Biegeaktuatoren z.B. in Blindenlesegeräten oder in Pneumatikventilen. Dabei schalten sie zwischen zwei durch feste Anschläge definierten Endlagen hin und her und üben auf die Anschläge bestimmte Kräfte aus. Je nach Anwendung werden solche Bieger bezüglich Weg, Kraft, Baugröße, Betriebsspannung usw. unterschiedlich optimiert.

Nachteilig ist dabei, daß sich mit größer werdender Auslenkung die Kraft, die auf einen Anschlag noch ausgeübt werden kann, linear verkleinert. Größere Kräfte können also nur zu Lasten kleinerer Auslenkungen erzielt werden. Ein weiterer Nachteil besteht darin, daß zur Aufrechterhaltung der Kraft auf den Anschlag die Ladespannung am Aktuator erhalten bleiben muß, um dielektrische und andere Verluste zu ergänzen.

Es ist die Aufgabe der Erfindung, einen piezoelektrisch angetriebenen Biegeaktuator und ein Betriebsverfahren für diesen zu schaffen, mit dem bei großer Auslenkung eine große Druckkraft auf den Anschlag erzielt werden kann.

Diese Aufgabe wird nach der Erfindung vorrichtungsmäßig gemäß Anspruch 1 gelöst. Ferner besteht die weitere Lösung der Aufgabe erfindungsgemäß in dem Verfahren nach Anspruch 25.

Bei einem Biegeaktuator mit einem piezoelektrischen Biegeglied, das durch Anlegen von Spannung zwischen wenigstens zwei Lagen schaltbar ist, ist demnach vorgesehen, daß eine mit dem Biegeglied zusammenwirkende Krafteinrichtung vorgesehen ist, die das Biegeglied beim Übergang in wenigstens eine seiner Lagen unterstützt. In den entsprechenden Lagen wird also durch die Krafteinrichtung eine zusätzliche Kraft auf das Biegeglied in Richtung auf diese Lage aufgebracht. Liegt das Biegeglied in den entsprechenden Lagen gegen ein einen Anschlag an, so wird es zusätzlich mit der durch die Krafteinrichtung aufgebrachten Kraft dagegen gedrückt.

Durch die mit dem Biegeglied zusammenwirkende Krafteinrichtung können somit eine größere Auslenkung und wesentlich größere Druckkräfte auf die Anschläge erzielt werden, als dies mit dem Biegeglied alleine möglich wäre. Dadurch, daS nämlich die Krafteinrichtung das Biegeglied zum Beibehalten wenigstens einer seiner Lagen beaufschlagt, wird in dieser Lage nicht nur die Kraft durch das Biegeglied selbst auf den entsprechenden Anschlag in dieser Lage ausgeübt, sondern auch die Krafteinrichtung drückt das Biegeglied gegen den Anschlag. Auf letzteren wirkt somit die Summe der Kräfte des Biegegliedes und der Krafteinrichtung.

Ein Vorteil der Vorrichtung und des Verfahrens nach der Erfindung besteht ferner darin, daß diese piezoelektrisch angetriebene Anordnung durch einen zeitlich begrenzten Umladeimpuls in eine andere Lage geschaltet werden kann, ohne daß nach dem Umschalten eine Erhaltung der Ladung nötig ist. Es wirkt dann also nur die Krafteinrichtung.

Bevorzugt ist die Krafteinrichtung nach Anspruch 2 in einem Bereich des Schaltweges des Biegegliedes wirkungslos. Anders ausgedrückt übt die Krafteinrichtung in diesem Bereich auf das Biegeglied keine Kraft aus oder alle durch die Krafteinrichtung verursachten Kräfte auf das Biegeglied sind in diesem Bereich im Gleichgewicht. Die entsprechende Stellung des Biegegliedes ist somit labil. Je nach Ausführung der Krafteinrichtung ist dieser wirkungslose Bereich durch eine Gleichgewichtslage der Krafteinrichtung selbst oder durch einen Gleichgewichtsort innerhalb der Krafteinrichtung, wenn diese z.B. ein Feld erzeugt, bestimmt.

Vorzugsweise entspricht der wirkungslose Bereich der Krafteinrichtung einer Schaltlage des Biegegliedes, wie in Anspruch 3 angegeben ist. Gemäß der Weiterbildung nach Anspruch 4 hat das Biegeglied eine Totpunktlage, die dem wirkungslosen Bereich der Krafteinrichtung entspricht. Damit wird insgesamt der Vorteil erreicht, daß das Biegeglied im wirkungslosen Bereich der Krafteinrichtung kräftefrei einen definierten Schaltzustand einnimmt, aus dem sie ohne Aufbringung größerer Kräfte leicht und schnell umgeschaltet werden kann, insbesondere, wenn die Krafteinrichtung im wirkungslosen Bereich einen labilen Zustand einnimmt. Dieser Effekt ist dann besonders von Vorteil, wenn die Totpunktlage des Biegeglieds und der wirkungslose Bereich der Krafteinrichtung zusammenfallen, da das Biegeglied dabei die entsprechende Lage besonders genau und ohne weiteren Aufwand einnehmen kann. Der Schaltzustand oder die Schaltlage des Biegegliedes im kräftefreien Bereich der Krafteinrichtung kann beispielsweise mittels elektrischer Regeleinrichtungen realisiert werden. Ferner können Einrichtungen vorgesehen werden, die ein "Einfangen" des Biegeglieds in seiner Totpunktlage unterstützen, wie z.B. ein zeitlich steuerbarer Elektromagnet, der auf das Biegeglied im wirkungslosen Bereich der Krafteinrichtung zeitlich begrenzt einwirkt, damit das Biegeglied beim Schaltübergang dort angehalten wird.

Die Ansprüche 5 und 7 geben verschiedene bevorzugte Schaltmöglichkeiten für den erfindungsgemäßen Biegeaktuator an, der jeweils eine Totpunktlage hat. Dabei ist das Biegeglied zwischen seiner Totpunktlage und wenigstens einer Endlage, zwischen zwei von seiner Totpunktlage verschiedenen Endlagen bzw. zwischen seiner Totpunktlage und zwei verschiedenen Endlagen schaltbar. Bei den beiden ersten Alternativen liegt somit eine bistabile Auslenkcharakteristik in je zwei Lagen vor. Der Biegeaktuator der dritten Alternative hat drei Schaltzustände. Der Vorteil des erfindungsgemäßen Biegeaktuators liegt somit ersichtlich ferner darin, daß er vielfältig einsetzbar ist, ohne daß grundsätzliche bauliche Veränderungen erforderlich sind.

Bei einem vorzugsweisen Aufbau enthält das Biegeglied gemäß Anspruch 8 wenigstens zwei Piezokeramikstreifen. Ein derartiges Biegeglied wird auch als Piezo-Bimorph bezeichnet. Weiterhin können diese Piezokeramikstreifen insbesondere miteinander verklebt sein. Weiterhin können nach Anspruch 9 an die Piezokeramikstreifen zum Schalten des Biegegliedes untereinander verschiedene Spannungen anlegbar sein. Die unterschiedlichen Spannungen hängen dabei von den Polarisationen der Piezokeramikschichten oder -streifen ab. Werden z.B. an zwei miteinander verklebte Piezokeramikstreifen unterschiedliche Spannungen angelegt, so ergeben sich Längenunterschiede zwischen beiden Streifen. Dabei verbiegt sich die Einheit ähnlich wie bekannte Bimetall-Federn bei Temperaturänderung. Ein derartiger Biegeaktuator kann somit einfach, genau, dauerhaft, schnell und sicher geschaltet werden.

Eine bevorzugte Ausführungsform des erfindungsgemäßen Biegeaktuators ist in Anspruch 9 angegeben. Dabei ist die Krafteinrichtung eine bistabile Feder. Das Biegeglied ist dann mechanisch mit der Feder gekoppelt. Diese Ausführung ist vorteilhaft, da sie sehr günstig und einfach aufgebaut ist. Wie bereits oben erwähnt wurde, kann der wirkungslose Bereich der Krafteinrichtung bei dieser Ausführungsform durch eine Gleichgewichtslage der bistabilen Feder bestimmt sein, wie im Anspruch 10 angegeben ist.

Bei einer alternativen vorzugsweisen Ausführungsform nach Anspruch 11 ist die Krafteinrichtung des Biegeaktuators eine Magnetanordnung mit einem Magnetfeld. Das Biegeglied ist dabei durch das Magnetfeld mit der Magnetanordnung gekoppelt. Durch das Fehlen von weiteren mechanischen Komponenten wird dabei der Vorteil erreicht, daß keine weiteren Teile verwendet werden, die einem Verschleiß unterliegen, so daß die Anordnung sehr zuverlässig und langlebig ist.

Eine bevorzugte Weiterbildung dieser Ausführung besteht gemäß Anspruch 12 darin, das Biegeglied ein Kopplungselement enthält, das ferromagnetisches Material, insbesondere Stahl, enthält und im Bereich des Magnetfeldes angeordnet ist. Dabei kann das Kopplungselement insbesondere eine Stahlzunge sein.

Bevorzugt ist ferner, wenn bei der Ausführung mit der Magnetanordnung das Magnetfeld stark nichtlinear ist. Dies kann in vorteilhafter Weise dadurch erreicht werden, daß die Magnetanordnung zwei mit gleichnamigen Polen zueinander gerichtete Permanentmagnete enthält. Diese Ausführung ist sehr einfach, genau und kostengünstig. Ferner ist keine Leistung zur Erzeugung des Magnetfeldes erforderlich, wenn Permanentmagneten verwendet werden.

Bei Verwendung einer Magnetanordnung ist der wirkungslose Bereich der Krafteinrichtung durch einen Gleichgewichtsort der Kräfte des Magnetfeldes auf das Biegeglied bestimmt.

Nach Anspruch 13 ist vorgesehen, daß das Biegeglied zum Schalten durch Spannungsimpulse beaufschlagbar ist. Dadurch wird der Vorteil ausgenutzt, daß zum Erhalten der Schaltlage des Biegegliedes keine Erhaltung der Ladung darin notwendig ist. Vorteilhaft ist dabei ferner, wenn die Spannungsimpulse eine vorgegebene oder eine wählbare und insbesondere steuerbare Dauer haben können. Damit ist der Biegeaktuator sehr genau in seine Schaltlagen steuerbar. Bevorzugt ist dafür eine elektrische Impulsansteuerschaltung zur Erzeugung der Spannungsimpulse vorgesehen. Dabei ist es gemäß bevorzugter Ausführungsbeispiele ausreichend, die Impulse so zu gestalten, daß sie lediglich z.B. das Umschnappen eines bistabilen Biegeaktuators zwischen zwei Endschaltlagen bewirken, um eine einfache Ansteuerung und Auslösung zu erreichen. Soll außer genauen Schaltzeitpunkten auch eine genaue Ansteuerung einer Schaltlage realisiert werden, ist ein zusätzlicher Aufwand erforderlich.

Eine besonders einfache elektrische Ansteuerung wird mit der im Anspruch 15 angegebenen Impulsansteuerschaltung erreicht. Diese enthält eine Kapazität (C1), die über einen Transistor aufgeladen wird, wobei der Ladestrom die Primärwicklung eines Koppeltransformators durchfließt und auf dessen Sekundärseite ein zum Umschalten des Biegeaktuators hinreichender Spannungsimpuls erzeugt wird. Ferner kann vorgesehen sein, daß die Impulsansteuerschaltung einen Transistor enthält, durch den beim Abschalten der Versorgungsspannung der Entladestrom fließt und analog einen Spannungsimpuls mit negativem Vorzeichen erzeugt. Weiterhin kann die Impulsansteuerschaltung eine aus Dioden bestehende Impulsaufteilung enthalten, wodurch je nach Vorzeichen des Spannungsimpulses die richtige Seite des Biegeaktuators beaufschlagt wird.

Es ist vorteilhaft, wenn das Biegeglied im Bereich seiner Totpunktlage eine größere Biegekraft hat als im Bereich einer Schaltlage. Dies ermöglicht ein sicheres Schalten aus der Totpunktlage.

Es ist ferner bevorzugt und vorteilhaft, wenn der Biegeaktuator eine derartige Krafteinrichtung hat, die ihre maximale Kraft im Bereich wenigstens einer End- oder Schaltlage des Biegegliedes hat. Dies ermöglicht besonders stabile Schaltzustände.

Die Ausführung nach Anspruch 19 ermöglicht eine weitere individuelle Anpassung des erfindungsgemäßen Biegeaktuators an unterschiedlichste Schaltanforderungen. Es kann nämlich ausreichend sein, wenn das Biegeglied in wenigstens einer Lage zumindest im wesentlichen durch die Krafteinrichtung gehalten wird. Bevorzugt ist es jedoch, wenn das Biegeglied in wenigstens zwei Endlagen ausschließlich durch die Krafteinrichtung gehalten wird.

Bevorzugt ist in wenigstens einer Schaltlage des Biegegliedes ein Anschlag vorgesehen, gegen den das Biegeglied in der Schaltlage anliegt.

Ein erfindungsgemäßer Biegeaktuator wird bevorzugt in der Weise betrieben, daß das piezoelektrische Biegeglied durch Anlegen einer Spannung aus einer ersten Lage wenigstens soweit herausbewegt wird, bis es von der Krafteinrichtung in Richtung von der ersten Lage weg beaufschlagt wird, und daß die Krafteinrichtung dann das piezoelektrische Biegeglied in einer zweiten Lage beaufschlagt. Eine vorteilhafte Weiterbildung besteht darin, daß die Krafteinrichtung das piezoelektrische Biegeglied schließlich zumindest im wesentlichen in der zweiten Lage hält. Dabei ist es besonders bevorzugt, wenn die Krafteinrichtung das piezoelektrische Biegeglied ausschließlich in der zweiten Lage hält, wenn es sich dabei um eine Endlage handelt, die nicht mit der Totpunktlage des Biegegliedes identisch ist.

Weitere vorteilhafte Ausgestaltungen der Erfindung ergeben sich aus den Kombinationen der Unteransprüche.

Die Erfindung wird nachfolgen anhand in der Zeichnung dargestellter Ausführungsbeispiele näher beschrieben. In der Zeichnung zeigen:
- Fig. 1: ein erstes Ausführungsbeispiel eines erfindungsgemäßen Biegeaktuators mit einem Biegeglied und einer Krafteinrichtung,
- Fig. 2: eine Kraft-Weg-Kennlinie nur des Biegegliedes des Piezo-Biegeaktuators aus Fig. 1,
- Fig. 3: eine Kraft-Weg-Kennlinie einer bistabilen Feder als Krafteinrichtung gemäß dem Ausführungsbeispiel aus Fig. 1,
- Fig. 4: einen Kraft-Weg-Verlauf des Piezo-Biegeaktuators mit einer an dessen Biegeglied gekoppelten bistabilen Feder nach Fig. 1, d.h. die überlagerten Kennlinien aus den Fig. 2 und 3,
- Fig. 5: ein zweites Ausführungsbeispiel eines erfindungsgemäßen Biegeaktuators,
- Fig. 6: eine Kraft-Weg-Kennlinie nur des Magnetfeldes einer Magnetanordnung gemäß dem zweiten Ausführungsbeispiel des erfindungsgemäßen Biegeaktuators nach Fig. 5,
- Fig. 7: einen Kraft-Weg-Verlauf des Piezo-Biegeaktuators nach Fig. 5 mit einer Magnetanordnung, die durch ihr Magnetfeld mit dem Biegeglied gekoppelt ist (d.h. die überlagerten Kennlinien aus den Fig. 2 und 6),
- Fig. 8: das Schaltbild eines Ausführungsbeispiels einer Impulsansteuerschaltung für einen erfindungsgemäßen Piezo-Biegeaktuator,
- Fig. 9: eine grundlegende Skizze des Bieger-Prinzips im Zusammenhang mit einem Biegeaktuator mit einem weiteren Ausführungsbeispiel des Biegeglieds,
- Fig. 10: einen Impulsplan der Impulsansteuerung von Fig. 8,
- Fig. 11: einen prinzipiellen Schaltplan der Biegeransteuerung mit der Impulsansteuerschaltung aus Fig. 8,
- Fig. 12: eine Skizze eines erfindungsgemäßen Biegeaktuators zur Verdeutlichung einer ersten Schaltlage,
- Fig. 13: eine Skizze eines erfindungsgemäßen Biegeaktuators zur Verdeutlichung einer zweiten Schaltlage, und
- Fig. 14: eine Skizze eines erfindungsgemäßen Biegeaktuators zur Verdeutlichung seiner Totpunktlage.

In der Zeichnung sind gleiche Teile durchgehend mit gleichen Bezugszeichen versehen.

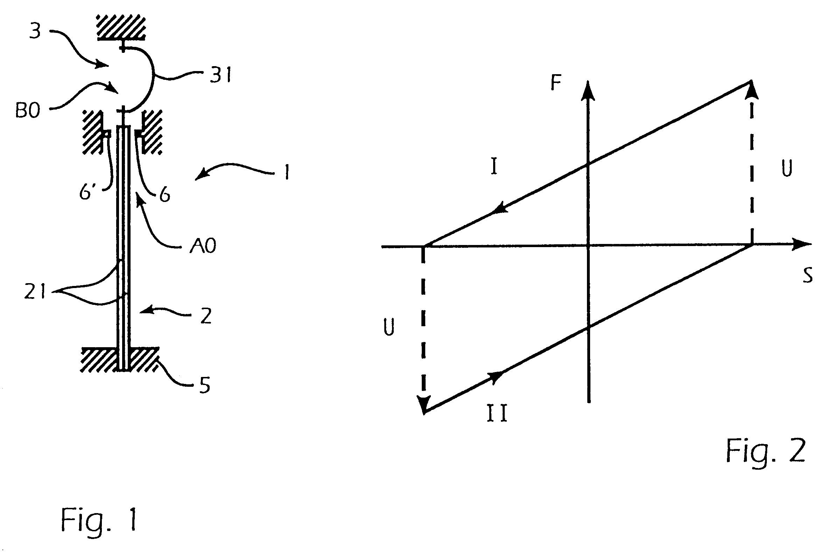

In Fig. 1 ist ein erstes Ausführungsbeispiel eines Biegeaktuators 1 gezeigt, der ein piezoelektrisches Biegeglied 2 enthält. Dieses besteht aus zwei dünnen Streifen 21 aus Piezokeramik, die miteinander verklebt sind und somit ein sog. Piezo-Bimorph bilden. An die beiden Piezokeramikstreifen 21 können unterschiedliche Spannungen so angelegt werden, daß sich Längenunterschiede zwischen den beiden Piezokeramikstreifen 21 ergeben und sich das Biegeglied 2 dadurch verbiegt.

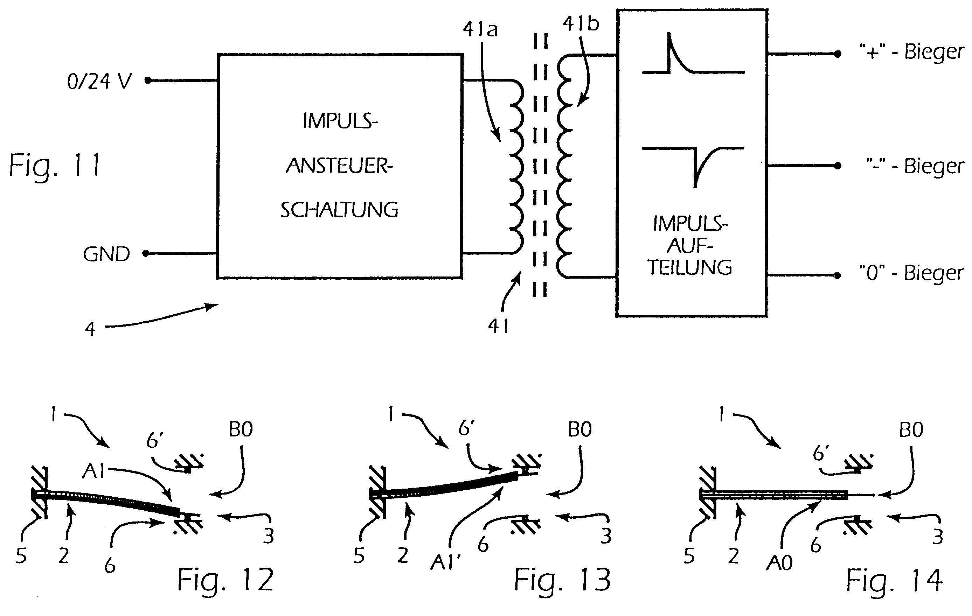

Die Zustände, die das Biegeglied dabei grundsätzlich einnehmen kann, sind aus den Fig. 12 bis 14 ersichtlich. In Fig. 14 ist das Biegeglied 2, ebenso wie in Fig. 1, in einer Totpunktlage A0 gezeigt, in der keine Spannungen an den Piezokeramikstreifen 21 angelegt sind und die bei einem bistabilen Biegeaktuator 1 gemäß den in den Figuren gezeigten Ausführungsbeispielen nicht stabil ist. Eine erste Schaltlage oder Endlage A1 ist in Fig. 12 gezeigt, wo das Biegeglied 2 durch Anlegen bestimmter Spannungen an einem Anschlag 6 anliegt. Werden die Spannungen in vorgegebener Weise geändert, so schaltet das Biegeglied 2 in eine zweite Schaltlage oder Endlage A1' um, die in Fig. 13 gezeigt ist und in der das Biegeglied an einem zweiten Anschlag 6' anliegt. Zwischen den einzelnen Schaltzuständen A0, A1, A1' verändert nur das freie Ende des Biegegliedes 2 seine Lage. Das andere Ende des Biegegliedes 2 ist in einer Einspannung 5 festgehalten, wie auch Fig. 1 zeigt.

Der in Fig. 1 gezeigte Biegeaktuator 1 enthält ferner eine bistabile Feder 31 als eine Krafteinrichtung 3, mit der das Biegeglied 2 gekoppelt ist. Die bistabile Feder 31 bzw. allgemein die Krafteinrichtung 3 hat eine labile Gleichgewichtslage, die in der Zeichnung mit B0 bezeichnet ist und einen Bereich angibt, in der die bistabile Feder 31 wirkungslos ist, d.h. keine Kraft auf das Biegeglied 2 ausübt. Wie die Fig. 1 und 14 zeigen, fallen bei dem dargestellten Ausführungsbeispiel die Totpunktlage A0 des Biegegliedes und die Gleichgewichtslage der bistabilen Feder 31 bzw. der Krafteinrichtung zusammen. Ist das freie Ende des Biegegliedes 2 in der Gleichgewichtslage B0 der bistabilen Feder 31 angeordnet, so wirkt sich die in dieser Gleichgewichtslage B0 befindliche Feder 31 nicht auf das Biegeglied 2 in verstellender Weise aus, d.h. übt keine Kraft in Richtung auf eine Endlage A1 oder A1' bzw. einen Anschlag 6 oder 6' auf das Biegeglied 2 aus.

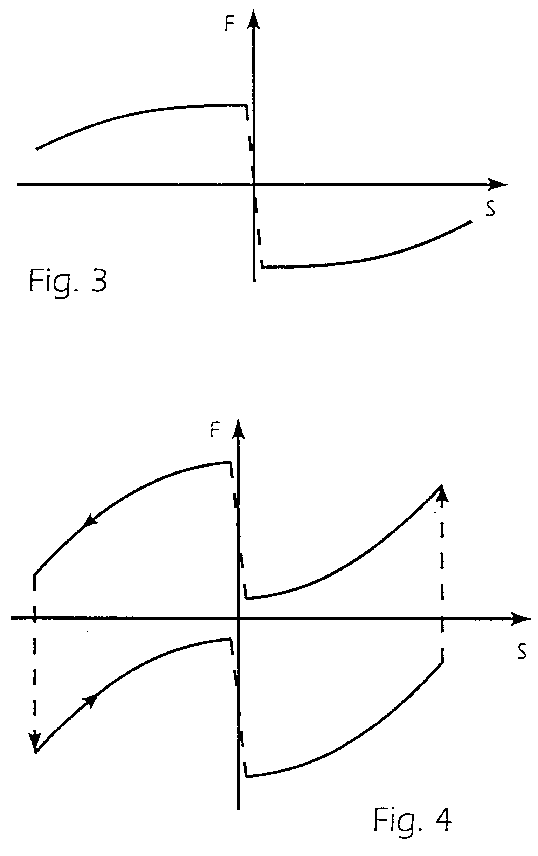

Die Kraft-Weg-Kennlinie eines reinen Piezobiegers 2 ist in Fig. 2 dargestellt. Die Kennlinie I entspricht der piezoelektrischen Auslenkung S zum Anschlag 6' hin in die Endlage A1' und die Kennlinie II der zum Anschlag 6 hin in die Endlage A1. Mit U sind die Umschaltvorgänge bezeichnet. Es ist deutlich zu erkennen, daß die Kraft F im Bereich der Endlagen A1 bzw. A1' gegen Null geht. Kombiniert man diesen Verlauf mit der in Fig. 3 gezeigten Kennlinie einer bistabilen Feder 31, also die in Richtung der Biegeauslenkung S wirksame Komponente der Feder-Kompressionskraft F, so ergibt sich ein bistabiler Kraft-Weg-Verlauf, wie er in Fig. 4 dargestellt ist.

Bedingung für die Funktion ist, daß bei Umschalten die Biegekraft in der Nähe der Mittelstellung (= Ursprung der S-Achsen) mindestens so groß ist, daß die hier große entgegengerichtete Federkraft überwunden wird. Dieser Sachverhalt ist entscheidend für die Dimensionierung des Systems.

Nach Überschreiten des Totpunktes (= Ursprung der F-Achsen) kehrt sich die Richtung der Federkraft um und beide Kräfte addieren sich nun, so daß die Kraftwirkung gegen den Anschlag im wesentlichen durch die Federwirkung der bistabilen Feder 31 bestimmt wird. Beim Umschalten der Ladespannung des Biegeglieds 2 bzw. dessen Piezokeramikstreifen 21 läuft der Vorgang in entgegengesetzter Richtung ab.

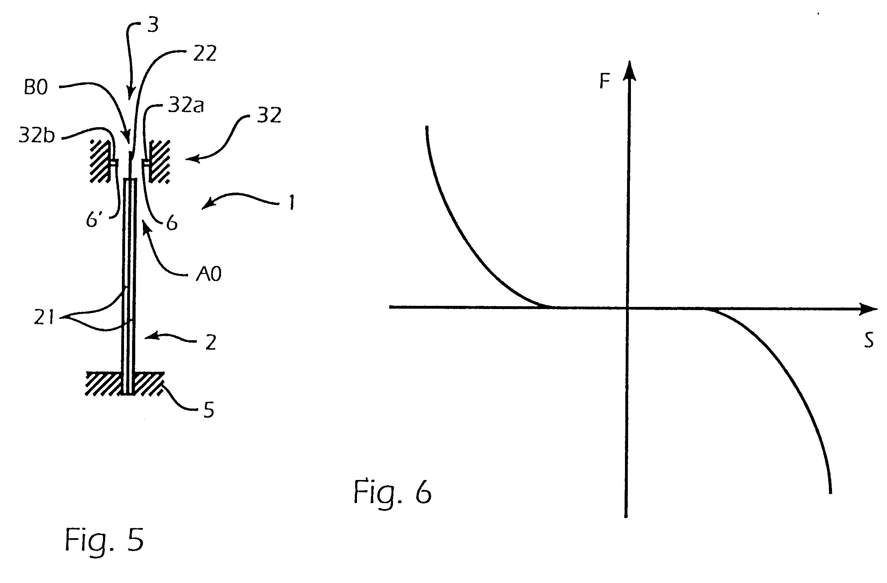

Ein zweites Ausführungsbeispiel eines Biegeaktuators 1 ist in Fig. 5 gezeigt. Hier arbeitet das mit einer Stahlzunge als Kopplungselement 22 versehene freie Biegerende in einem stark nichtlinearen Magnetfeld einer Magnetanordnung 32. Diese ist durch zwei mit gleichnamigen Polen zueinander gerichtete Permanentmagneten 32a und 32b realisiert, die an den Anschlägen 6 bzw. 6' angeordnet sind. Im übrigen unterschiedet sich dieses Ausführungsbeispiel nicht von dem in Fig. 1 gezeigten.

Der wirkungslose Bereich der Magnetanordnung 32 ist in diesem Fall durch den Gleichgewichtsort B0 bestimmt, an dem sich die Kräfte des durch die beiden Permanentmagneten 32a und 32b erzeugten Magnetfeldes aufheben. Wenn sich das Biegeglied 2 mit seinem freien Ende an diesem Gleichgewichtsort B0 befindet, wird seine Lage von dem Magnetfeld nicht beeinflußt. Das in der hier gezeigten Ausführungsform in seiner Totpunktlage A0 befindliche Biegeglied 2 wird durch das Magnetfeld alleine nicht in Richtung auf einen Anschlag 6 oder 6' bzw. in eine seiner Schaltlagen A1 oder A1' gezwungen.

Die möglichen Schaltstellungen dieses zweiten Ausführungsbeispiels sind wiederum den Fig. 12 bis 14 zu entnehmen, die bereits weiter oben beschrieben wurden, was hier analog gilt.

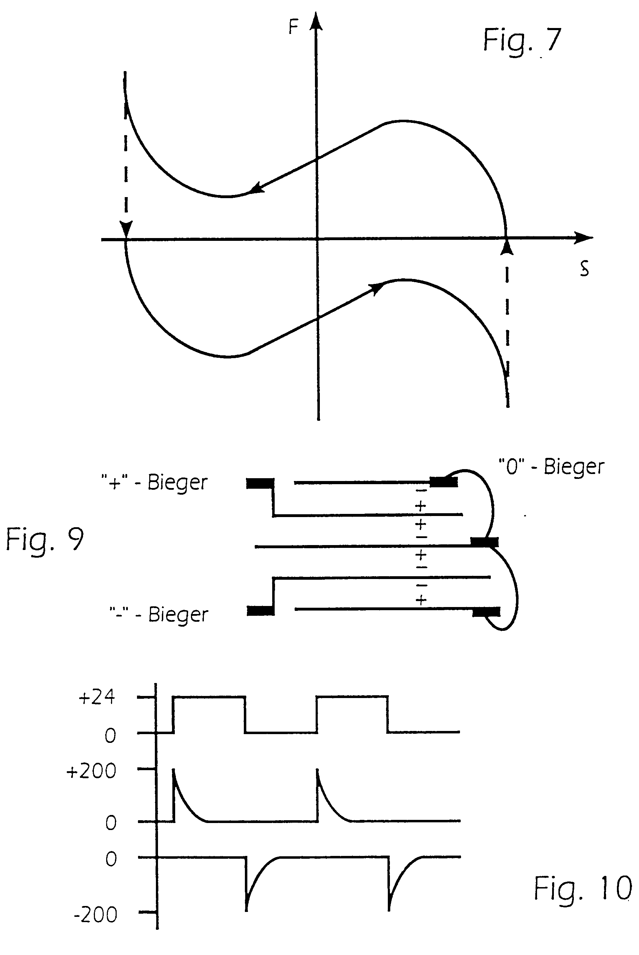

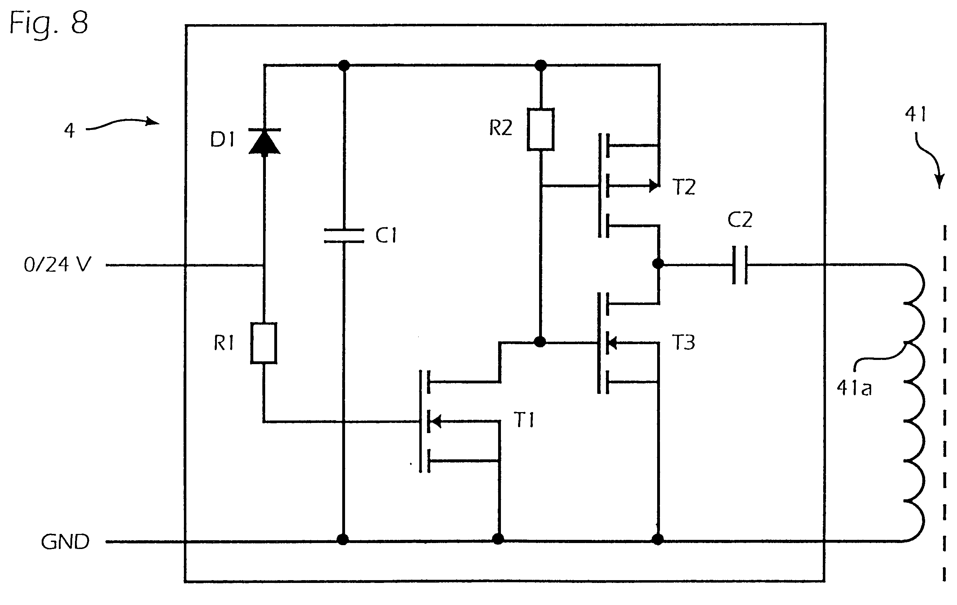

Die Kraft-Weg-Kennlinie der Stahlzunge 22 alleine in dem Magnetfeld ist in Fig. 6 dargestellt. Bei der Überlagerung mit der Biegerkennlinie aus Fig. 2 ergibt sich als Systemkennlinie der Verlauf aus Fig. 7. Hier wird die Kraft des Biegers 2 nur zur Überwindung der magnetischen Kaltekraft zwischen Stahlzunge 22 und Anschlag 6 bzw. 6' benötigt.

Mit der magnetischen Anordnung sind auch einseitig wirkende Anordnungen möglich oder solche Anordnungen, die eine dritte stabile Lage im Null- oder Totpunkt A0 einnehmen können. Hierfür kann ein Spannungsimpuls zum Lösen aus der Endlage A1 (und/oder A1') verwendet werden, der so kurz ist, daß das Biegeglied 2 nicht über die Totpunktlage A0 hinausgeht und ggf. in den Feldbereich des zweiten Magneten kommt. Grundsätzlich sind aber auch nichtmagnetische Krafteinrichtungen zur Realisierung derartiger Schalter konstruierbar.

In Fig. 8 ist eine elektrische Schaltung 4 zur Erzeugung des erforderlichen Stromimpulses zur Stoßanregung des Aktuators 1 gezeigt.

Beim Anlegen der Ansteuerspannung wird in der Impulsansteuerschaltung 4 eine Kapazität C1 über den Transistor T2 aufgeladen, wobei der Ladestrom die Primärwicklung 41a eines Koppeltransformators 41 durchfließt und auf dessen Sekundärseite 41b ein zum "Umschnappen" oder Umschalten des bistabilen Aktuators 1 hinreichender Spannungsimpuls erzeugt wird. Der durch den Transistor T3 fließende Entladestrom beim Abschalten der Versorgungsspannung erzeugt analog einen Spannungsimpuls mit negativem Vorzeichen. Die aus Dioden bestehende Impulsaufteilung, die aus Fig. 11 ersichtlich ist, sorgt dafür, daß je nach Vorzeichen des Spannungsimpulses die Richtige Seite des Biegegliedes 2 des Biegeaktuators 1 beaufschlagt wird. Der Masseanschluß der Impulsansteuerschaltung 4 ist mit GND bezeichnet und am anderen Anschluß wird eine Spannung von 0 oder 24 V angelegt.

Eine grundsätzliche Skizze, die das Bieger-Prinzip veranschaulicht, ist in Fig. 9 gezeigt. Hier sind vier piezoelektrisch aktive Schichten gezeigt, die das Biegeglied bilden. Die jeweilige Polarisierung der Lagen ist mit "+" bzw. "-" angegeben. Mit einer derartigen vierlagigen Ausführung kann eine größere Biegeauslenkung und/oder Kraftwirkung erzielt werden, als mit den beiden vorstehend beschriebenen zweilagigen Ausführungsbeispielen.

Die jeweils außen liegenden Oberflächen des Biegeglieds von Fig. 9 sind elektrisch auf einem Null-Potential. Dies ist vorteilhaft, da dadurch keine Isolationsmaßnahmen erforderlich sind. Die Bezeichnung "0"-Bieger bezieht sich also auf jene Flächen, die bei der Anregung auf Nullpotential bleiben.

Fig. 10 verdeutlicht den Impulsplan der Biegeransteuerung.

Lediglich beispielhaft werden nachfolgend Größen einer Ausführungsform eines Biegeaktuators 1 angegeben: Ein Piezo-Bimorph-Biegeglied 2 mit dem Maßen 55 mm x 5 mm x 0,6 mm hat bei Ansteuerung mit 300 V eine Auslenkung von ± 0,7 mm und eine Blockierkraft von 20 cN. Beim Endausschlag (A1 oder A1') in 0,7 mm Abstand von der Ruhe- oder Totpunktlage A0 wird die Kraft durch das piezoelektrische Biegeglied 2 auf den Anschlag 6 oder 6' zu Null. Eine Anordnung mit Magneten 32a und 32b funktioniert bis zu Auslenkungen von ± 2 mm und wirkt auf einen Anschlag 6 oder 6' in 0,7 mm Abstand vom Gleichgewichtszustand B0 der Magnetanordnung 32, d.h. in diesem Fall auch von der Ruhe- oder Totpunktlage A0, mit einer Kraft von bis zu 20 cN.

Die angegebenen Ausführungsbeispiele dienen lediglich der Verdeutlichung der Erfindung, deren gesamter Umfang insbesondere durch die Ansprüche und die Darstellungen in der Beschreibungseinleitung gegeben ist.

## Patentansprüche

1. Biegeaktuator mit einem piezoelektrischen Biegeglied, das durch Anlegen von Spannung zwischen wenigstens zwei Lagen schaltbar ist, dadurch **gekennzeichnet**, daß eine mit dem Biegeglied (2) zusammenwirkende Krafteinrichtung (3) vorgesehen ist, die das Biegeglied (2) beim Übergang in wenigstens eine seiner Schaltlagen (A1, A1') unterstützt.

2. Biegeaktuator nach Anspruch 1, dadurch **gekennzeichnet**, daß die Krafteinrichtung (3) in einem Bereich (B0) des Schaltweges des Biegegliedes (2) wirkungslos ist.

3. Biegeaktuator nach Anspruch 2, dadurch **gekennzeichnet**, daß der wirkungslose Bereich (B0) der Krafteinrichtung (3) einer Schaltlage (A0) des Biegegliedes (2) entspricht.

4. Biegeaktuator nach Anspruch 3, dadurch **gekennzeichnet**, daß das Biegeglied (2) eine Totpunktlage (A0) aufweist, und daß die Schaltlage des Biegegliedes (2), die dem wirkungslosen Bereich (B0) der Krafteinrichtung (3) entspricht, die Totpunktlage (A0) des Biegegliedes (2) ist.

5. Biegeaktuator nach einem der vorhergehenden Ansprüche, dadurch **gekennzeichnet**, daß das Biegeglied (2) eine Totpunktlage (A0) aufweist, und daß das Biegeglied (2) zwischen seiner Totpunktlage (A0) und wenigstens einer Endlage (A1, A1') schaltbar ist.

6. Biegeaktuator nach einem der Ansprüche 1 bis 4, dadurch **gekennzeichnet**, daß das Biegeglied (2) eine Totpunktlage (A0) aufweist, und daß das Biegeglied (2) zwischen zwei von seiner Totpunktlage (A0) verschiedenen Endlagen (A1, A1') schaltbar ist.

7. Biegeaktuator nach einem der vorhergehenden Ansprüche, dadurch **gekennzeichnet**, daß das Biegeglied (2) wenigstens zwei Piezokeramikstreifen (21) enthält, und daß die Piezokeramikstreifen (21) insbesondere miteinander verklebt sind.

8. Biegeaktuator nach Anspruch 7, dadurch **gekennzeichnet**, daß an die Piezokeramikstreifen (21) zum Schalten des Biegegliedes (2) untereinander verschiedene Spannungen anlegbar sind.

9. Biegeaktuator nach einem der vorhergehenden Ansprüche, dadurch **gekennzeichnet**, daß die Krafteinrichtung (3) eine bistabile Feder (31) ist.

10. Biegeaktuator nach Anspruch 9, dadurch **gekennzeichnet**, daß der wirkungslose Bereich der Krafteinrichtung (3) durch eine Gleichgewichtslage (B0) der bistabilen Feder (31) bestimmt ist.

11. Biegeaktuator nach einem der Ansprüche 1 bis 8, dadurch **gekennzeichnet**, daß die Krafteinrichtung (3) eine Magnetanordnung (32) mit einem Magnetfeld ist.

12. Biegeaktuator nach Anspruch 11, dadurch **gekennzeichnet**, daß das Biegeglied (2) ein Kopplungselement (22) aus ferromagnetischem Material, insbesondere Stahl, enthält, das im Bereich des Magnetfeldes angeordnet ist.

13. Biegeaktuator nach einem der vorhergehenden Ansprüche, dadurch **gekennzeichnet**, daß das Biegeglied (2) zum Schalten durch Spannungsimpulse beaufschlagbar ist, die durch eine elektrische Impulssteuerschaltung erzeugt werden.

14. Biegeaktuator nach Anspruch 13, dadurch **gekennzeichnet**, daß die Dauer der Spannungsimpulse steuerbar ist.

15. Biegeaktuator nach Anspruch 13 oder 14, dadurch **gekennzeichnet**, daß die Impulsansteuerschaltung (4) eine Kapazität (C1) enthält, die über einen Transistor (T2) aufgeladen wird, wobei der Ladestrom die Primärwicklung (41a) eines Koppeltransformators (41) durchfließt und auf dessen Sekundärseite (41b) ein zum Umschalten des Biegeaktuators (1) hinreichender Spannungsimpuls erzeugt wird.

16. Biegeaktuator nach einem der Ansprüche 13 bis 15, dadurch **gekennzeichnet**, daß die Impulsansteuerschaltung (4) einen Transistor (T3) enthält, durch den beim Abschalten der Versorgungsspannung der Entladestrom flieht und analog einen Spannungsimpuls mit negativem Vorzeichen erzeugt.

17. Biegeaktuator nach einem der Ansprüche 15 bis 16, dadurch **gekennzeichnet**, daß die Impulsansteuerschaltung (4) eine aus Dioden bestehende Impulsaufteilung enthält, wodurch je nach Vorzeichen des Spannungsimpulses die richtige Seite des Biegeaktuators beaufschlagt wird.

18. Biegeaktuator nach einem der vorhergehenden Ansprüche, dadurch **gekennzeichnet**, daß die Krafteinrichtung (3) ihre maximale Kraft im Bereich wenigstens einer Endlage (A1, A1') des Biegegliedes (2) hat.

19. Biegeaktuator nach einem der vorhergehenden Ansprüche, dadurch **gekennzeichnet**, daß das Biegeglied (2) in wenigstens einer Lage (A1, A1') zumindest im wesentlichen durch die Krafteinrichtung (3) gehalten wird.

20. Biegeaktuator nach einem der vorhergehenden Ansprüche, dadurch **gekennzeichnet**, daß in wenigstens einer Schaltlage (A1, A1') des Biegegliedes (2) ein Anschlag (6, 6') vorgesehen, gegen den das Biegeglied (2) in der Schaltlage (A1, A1') anliegt.
